# EUROPEAN PATENT APPLICATION

(11) **EP 3 624 177 A1**
(43) Date of publication of application: **18.03.2020**
(21) Application number: 18914930.5
(22) Date of filing: 03.08.2018
(51) Int. Cl.: H01L 21/78, H01L 21/56

(54) **CHIP PACKAGING METHOD**

(71) Applicant: Shenzhen Weitongbo Technology Co., Ltd., Shenzhen, Guangdong 518052 (CN)
(72) Inventor: The designation of the inventor has not yet been filed
(74) Representative: Pfenning, Meinig & Partner mbB
(86) International application number: PCT/CN2018/098583
(87) International publication number: WO 2020/024277

(57) **Abstract**

Embodiments of the present application relates to a chip packaging method. The method includes steps of: fabricating an insulating band on a scribe line of a wafer, where a front surface of the wafer is provided with a plurality of independent chip regions, and between any two adjacent chip regions, a depth of the insulating band is greater than or equal to a thickness of the chip region and less than or equal to a thickness of the wafer, and a width of the insulating band is less than or equal to a width of the scribe line; fabricating an insulating layer on an upper surface of the wafer; fabricating a plurality of holes on the insulating layer above each of the plurality of chip regions to expose each chip region; depositing a conductive material in the plurality of holes to form a plurality of bonding pads; and thinning a back surface of the wafer to obtain a packaged discrete device for the each chip region. The chip packaging method of the embodiments of the present application provides a chip packaging method, which could achieve insulation protection for a side surface of a wafer-level chip utilizing a semiconductor front-end process, a step of packaging a single chip at a back end is omitted, cost is lower, and a chip volume is smaller.

## Description

### TECHNICAL FIELD

The present application relates to the field of chips, and in particular, to a chip packaging method.

### BACKGROUND

In general, fabricating a semiconductor device may be divided into three steps: chip design, wafer fabrication (front end of the line), and packaging and testing (back end of the line). As an indispensable part in a semiconductor industry chain, packaging mainly plays a role in bringing out pins of a chip and isolating the chip from the exterior. In recent years, with continuous development towards a small-sized modern semiconductor device, not only does cost of packaging increase, but also a boundary between back-end packaging and front-end fabricating is gradually blurred, which means that a wafer foundry may also involves some packaging processes.

Compared with traditional packaging, wafer level chip scale packaging (Wafer Level Chip Scale Packaging, WLCSP) may effectively reduce a volume of a packaged surface mounted device (Surface Mounted Device, SMD) while ensuring low cost. However, WLCSP has poor sealing performance and a back surface and a side surface of a chip are not protected. When the SMD is mounted, it is possible to cause breakdown or short circuit of the device due to contact of an excessive amount of overflowed solder paste with the side surface of the chip.

Some people in the industry have proposed a packaging technology called eWLCSP (Encapsulated WLCSP). Simply stated, the eWLCSP requires to first process a wafer fabricated at a front end in a form of WLCSP and cut it into chips; then arrange the chips that pass the test on a carrier at a certain interval; encapsulate all the chips with a plastic packaging material and then cure them; and finally, perform secondary cutting to obtain discrete devices. This technology may effectively protect six surfaces of the chip, but the cost is relatively high.

Another technique is to use an injection mold to cover a plastic packaging material at a front surface and in a pre-formed scribe line of a wafer fabricated at a front end, and then combine a redistribution layer (Redistribution Layer, RDL) process, thinning of a back surface of the wafer and back surface plastic packaging to realize complete package of six surfaces of the chip. However, cost of this technology is relatively high due to the involved multiple packaging processes.

### SUMMARY

The present application provides a chip packaging method, which could achieve insulation protection for a side surface of a wafer-level chip utilizing a semiconductor front-end process, a step of packaging a single chip at a back end is omitted, cost is lower, and a chip volume is smaller.

According to a first aspect, a chip packaging method is provided, including: fabricating an insulating band on a scribe line of a wafer, where a front surface of the wafer is provided with a plurality of independent chip regions, a portion between any two adjacent chip regions of the plurality of chip regions is the scribe line, and between the any two adjacent chip regions, a depth of the insulating band is greater than or equal to a thickness of the chip region and less than or equal to a thickness of the wafer, and a width of the insulating band is less than or equal to a width of the scribe line; fabricating an insulating layer on an upper surface of the wafer; fabricating a plurality of holes on the insulating layer above each of the plurality of chip regions to expose each chip region; depositing a conductive material in the plurality of holes to form a plurality of bonding pads; and thinning a back surface of the wafer to obtain a packaged discrete device for the each chip region.

With reference to the first aspect, in an implementation manner of the first aspect, the fabricating the insulating band on the scribe line of the wafer includes: fabricating, on the scribe line, a trench surrounding the each chip region; and depositing an insulating material on an inner surface of the trench, such that the trench deposited the insulating material forms the insulating band, where a depth of the trench deposited the insulating material is greater than or equal to the thickness of the each chip region; and the thinning the back surface of the wafer to obtain the packaged discrete device for the each chip region includes: thinning the back surface of the wafer to separate the plurality of chip regions to obtain the packaged discrete device for the each chip region.

With reference to the first aspect and the foregoing implementation manners, in another implementation manner of the first aspect, the fabricating the insulating band on the scribe line of the wafer includes: fabricating, on the scribe line, a trench surrounding the each chip region, where a depth of the trench is greater than or equal to a thickness of a surrounded chip region and less than or equal to a thickness of the wafer; depositing an insulating material inside the trench to form the insulating band; the thinning the back surface of the wafer to obtain the packaged discrete device for the each chip region includes: thinning the back surface of the wafer to expose the insulating band, and dicing along the insulating band to obtain the packaged discrete device for the each chip region.

With reference to the first aspect and the foregoing implementation manners, in another implementation manner of the first aspect, the fabricating, on the scribe line, the trench surrounding the each chip region includes: fabricating the trench on the scribe line by means of at least one of dry etching, wet etching and mechanical cutting.

With reference to the first aspect and the foregoing implementation manners, in another implementation manner of the first aspect, the fabricating the trench on the scribe line by means of at least one of dry etching, wet etching and mechanical cutting includes: depositing a first protective layer on the upper surface of the wafer; fabricating a first window on the first protective layer above the scribe line; and etching the wafer in a first chemical solution to obtain the trench at the first window.

With reference to the first aspect and the foregoing implementation manners, in another implementation manner of the first aspect, the depositing the first protective layer on the upper surface of the wafer includes: depositing a silicon nitride layer as the first protective layer on the upper surface of the wafer by means of plasma assisted deposition, where the first chemical solution is any one of a potassium hydroxide solution, a sodium hydroxide (NaOH) solution, a tetramethylammonium hydroxide (TMAH) solution and a mixed solution containing hydrofluoric acid and nitric acid HNA.

With reference to the first aspect and the foregoing implementation manners, in another implementation manner of the first aspect, the trench is trapezoidal with a bottom width smaller than an upper width; or the trench is rectangular with a bottom width equal to an upper width.

With reference to the first aspect and the foregoing implementation manners, in another implementation manner of the first aspect, the fabricating the insulating band on the scribe line of the wafer includes: converting a portion of the scribe line surrounding the each chip region into a porous silicon region by electrochemical etching, where the porous silicon region is the insulating band; and the thinning the back surface of the wafer to obtain the packaged discrete device for the each chip region includes: thinning the back surface of the wafer to expose the insulating band, and dicing along the insulating band to obtain the packaged discrete device for the each chip region.

With reference to the first aspect and the foregoing implementation manners, in another implementation manner of the first aspect, the converting the portion of the scribe line surrounding the each chip region into the porous silicon region by the electrochemical etching includes: depositing a second protective layer on the upper surface of the wafer; fabricating a second window on the second protective layer above the scribe line; and placing the wafer in a second chemical solution to obtain the porous silicon region at the second window by the electrochemical etching.

With reference to the first aspect and the foregoing implementation manners, in another implementation manner of the first aspect, the depositing the second protective layer on the upper surface of the wafer includes: depositing a fluoropolymer layer as the second protective layer on the upper surface of the wafer by means of plasma assisted deposition, where the second chemical solution is a mixed solution containing hydrofluoric acid.

With reference to the first aspect and the foregoing implementation manners, in another implementation manner of the first aspect, the wafer includes an insulating layer, the insulating layer is disposed below the each chip region, and the insulating band and the insulating layer are connected.

With reference to the first aspect and the foregoing implementation manners, in another implementation manner of the first aspect, the thinning the back surface of the wafer to obtain the packaged discrete device for the each chip region includes: thinning the back surface of the wafer to expose the insulating layer, and dicing along the insulating band to obtain the packaged discrete device for the each chip region.

With reference to the first aspect and the foregoing implementation manners, in another implementation manner of the first aspect, the thinning the back surface of the wafer includes: thinning the back surface of the wafer by means of at least one of lapping, grinding, chemical mechanical polish, dry polishing, electrochemical etching, wet etching, plasma assisted chemical etching and atmospheric downstream plasma etching.

With reference to the first aspect and the foregoing implementation manners, in another implementation manner of the first aspect, the fabricating the insulating layer on the upper surface of the wafer includes: depositing an insulating material on the upper surface of the wafer to form the insulating layer.

With reference to the first aspect and the foregoing implementation manners, in another implementation manner of the first aspect, the depositing the insulating material includes: depositing the insulating material by means of at least one of physical vapor deposition, chemical vapor deposition, spraying and spin-coating.

With reference to the first aspect and the foregoing implementation manners, in another implementation manner of the first aspect, the insulating material includes at least one of a silicon oxide, a silicon nitride, and a polymer.

With reference to the first aspect and the foregoing implementation manners, in another implementation manner of the first aspect, the depositing the conductive material includes: depositing the conductive material by means of at least one of atomic layer deposition, physical vapor deposition, metal-organic chemical vapor deposition, evaporation, and electroplating.

With reference to the first aspect and the foregoing implementation manners, in another implementation manner of the first aspect, the conductive material includes at least one of heavily doped polysilicon, carbon-based material, metal, and titanium nitride.

According to a second aspect, a chip packaging method is provided, including: fabricating an insulating band on a scribe line of a wafer, where a front surface of the wafer is provided with a plurality of independent chip regions, a portion between any two adjacent chip regions of the plurality of chip regions is the scribe line, and between the any two adjacent chip regions, a depth of the insulating band is greater than or equal to a thickness of the chip region and less than or equal to a thickness of the wafer, and a width of the insulating band is less than or equal to a width of the scribe line; fabricating a first insulating layer on an upper surface of the wafer; fabricating a first window on the first insulating layer above each of the plurality of chip regions to expose each chip region; depositing a conductive material in the first window to form a first bonding pad of the each chip; and thinning a back surface of the wafer to expose the insulating band; and depositing a conductive material on a back surface of a thinned wafer to form a second bonding pad for the each chip region, and dicing along the insulating band to obtain a packaged discrete device for the each chip region.

With reference to the second aspect, in an implementation manner of the second aspect, the depositing the conductive material on the back surface of the thinned wafer to form the second bonding pad for the each chip region includes: depositing an insulating material on the back surface of the thinned wafer to form a second insulating layer; fabricating, on the second insulating layer below the each chip region, a second window to expose the each chip region; and depositing a conductive material in the second window to form the second bonding pad of the each chip.

With reference to the second aspect and the foregoing implementation manners, in another implementation manner of the second aspect, a material of the first insulating layer is the same as that of the second insulating layer.

With reference to the second aspect and the foregoing implementation manners, in another implementation manner of the second aspect, the fabricating the insulating band on the scribe line of the wafer includes: fabricating, on the scribe line, a trench surrounding the each chip region, where a depth of the trench is greater than or equal to a thickness of a surrounded chip region and less than or equal to a thickness of the wafer; and depositing an insulating material inside the trench to form the insulating band.

With reference to the second aspect and the foregoing implementation manners, in another implementation manner of the second aspect, the fabricating, on the scribe line, the trench surrounding the each chip region includes: fabricating the trench on the scribe line by means of at least one of dry etching, wet etching and mechanical cutting.

With reference to the second aspect and the foregoing implementation manners, in another implementation manner of the second aspect, the fabricating the trench on the scribe line by means of at least one of dry etching, wet etching and mechanical cutting includes: depositing a first protective layer on the upper surface of the wafer; fabricating a third window on the first protective layer above the scribe line; and etching the wafer in a first chemical solution to obtain the trench at the third window.

With reference to the second aspect and the foregoing implementation manners, in another implementation manner of the second aspect, the depositing the first protective layer on the upper surface of the wafer includes: depositing a silicon nitride layer as the first protective layer on the upper surface of the wafer by means of plasma assisted deposition, where the first chemical solution is any one of a potassium hydroxide solution, a sodium hydroxide (NaOH) solution, a tetramethylammonium hydroxide (TMAH) solution and a mixed solution containing hydrofluoric acid and nitric acid HNA.

With reference to the second aspect and the foregoing implementation manners, in another implementation manner of the second aspect, the trench is trapezoidal with a bottom width smaller than an upper width; or the trench is rectangular with a bottom width equal to an upper width.

With reference to the second aspect and the foregoing implementation manners, in another implementation manner of the second aspect, the fabricating the insulating band on the scribe line of the wafer includes: converting a portion of the scribe line surrounding the each chip region into a porous silicon region by electrochemical etching, where the porous silicon region is the insulating band.

With reference to the second aspect and the foregoing implementation manners, in another implementation manner of the second aspect, the converting the portion of the scribe line surrounding the each chip region into the porous silicon region by the electrochemical etching includes: depositing a second protective layer on the upper surface of the wafer; fabricating a fourth window on the second protective layer above the scribe line; and placing the wafer in a second chemical solution to obtain the porous silicon region at the fourth window by the electrochemical etching.

With reference to the second aspect and the foregoing implementation manners, in another implementation manner of the second aspect, the depositing the second protective layer on the upper surface of the wafer includes: depositing a fluoropolymer layer as the second protective layer on the upper surface of the wafer by means of plasma assisted deposition, where the second chemical solution is a mixed solution containing hydrofluoric acid.

With reference to the second aspect and the foregoing implementation manners, in another implementation manner of the second aspect, a material of the first bonding pad is the same as that of the second bonding pad.

With reference to the second aspect and the foregoing implementation manners, in another implementation manner of the second aspect, the thinning the back surface of the wafer includes: thinning the back surface of the wafer by means of at least one of lapping, grinding, chemical mechanical polish, dry polishing, electrochemical etching, wet etching, plasma assisted chemical etching and atmospheric downstream plasma etching.

With reference to the second aspect and the foregoing implementation manners, in another implementation manner of the second aspect, the fabricating the insulating layer on the upper surface of the wafer includes: depositing an insulating material on the upper surface of the wafer to form the insulating layer.

With reference to the second aspect and the foregoing implementation manners, in another implementation manner of the second aspect, the depositing the insulating material includes: depositing the insulating material by means of at least one of physical vapor deposition, chemical vapor deposition, plasma assisted deposition, spraying and spin-coating.

With reference to the second aspect and the foregoing implementation manners, in another implementation manner of the second aspect, the insulating material includes at least one of a silicon oxide, a silicon nitride, and a polymer.

With reference to the second aspect and the foregoing implementation manners, in another implementation manner of the second aspect, the depositing the conductive material includes: depositing the conductive material by means of at least one of atomic layer deposition, physical vapor deposition, metal-organic chemical vapor deposition, evaporation, and electroplating.

With reference to the second aspect and the foregoing implementation manners, in another implementation manner of the second aspect, the conductive material includes at least one of heavily doped polysilicon, carbon-based material, metal, and titanium nitride.

Optionally, the insulating band is grid-shaped as a whole, where the scribe lines on the wafer are grid-shaped as a whole, the chip regions are located between the grids, and corresponding grid-shaped insulating bands may be formed at corresponding positions of the grid-shaped scribe lines.

Therefore, according to a chip packaging method of an embodiment of the present application, an insulation protection method for a side surface of a wafer-level chip in a semiconductor front-end process is achieved by fabricating a trench surrounding chips and having an insulating material therein, or by fabricating a grid-shaped porous silicon region surrounding chips, so that a step of packaging a single chip at a back end is omitted, cost is lower, and a chip volume is smaller, thereby resolving a contradiction of insulation protection for a side surface of a semiconductor discrete device and complicated packaging procedures at the back end.

### BRIEF DESCRIPTION OF THE DRAWINGS

FIG. 1 is a schematic flowchart of a chip packaging method according to Embodiment 1 of the present application;
FIG. 2 is a top view of a wafer according to an embodiment of the present application;
FIG. 3 is a cross-sectional view of a wafer according to an embodiment of the present application;
FIGS. 4-8 are schematic structural diagrams of a wafer and a chip in each step of a chip packaging method of a first specific embodiment according to the chip packaging method of Embodiment 1 of the present application;
FIGS. 9-14 are schematic structural diagrams of a wafer and a chip in each step of a chip packaging method of a second specific embodiment according to the chip packaging method of Embodiment 1 of the present application;
FIGS. 15-19 are schematic structural diagrams of a wafer and a chip in each step of a chip packaging method of a third specific embodiment according to the chip packaging method of Embodiment 1 of the present application;
FIGS. 20-26 are schematic structural diagrams of a wafer and a chip in each step of a chip packaging method of a fourth specific embodiment according to the chip packaging method of Embodiment 1 of the present application;
FIG. 27 is a schematic flowchart of a chip packaging method according to Embodiment 2 of the present application;
FIGS. 28-31 are schematic structural diagrams of a wafer and a chip in each step of a chip packaging method of a first specific embodiment according to the chip packaging method of Embodiment 2 of the present application; and
FIGS. 32-37 are schematic structural diagrams of a wafer and a chip in each step of a chip packaging method of a second specific embodiment according to the chip packaging method of Embodiment 1 of the present application.

### DESCRIPTION OF EMBODIMENTS

Technical solutions in embodiments of the present application will be described hereinafter with reference to the accompanying drawings.

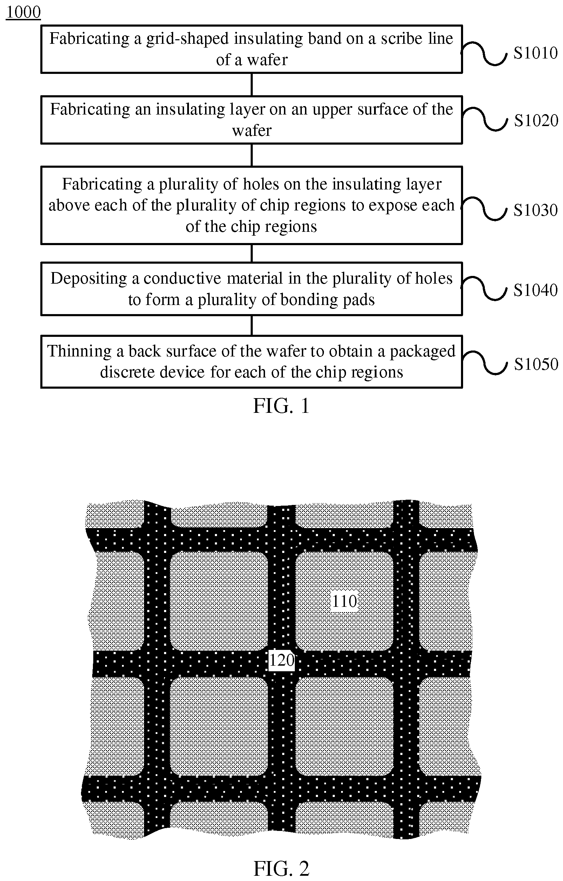

FIG. 1 shows a schematic flowchart of a chip packaging method 1000 according to an embodiment of the present application. As shown in FIG. 1, the method 1000 includes: S1010, fabricating an insulating band on a scribe line of a wafer, where a front surface of the wafer is provided with a plurality of independent chip regions, a portion between any two adjacent chip regions of the plurality of chip regions is the scribe line, and between the any two adjacent chip regions, a depth of the insulating band is greater than or equal to a thickness of the chip region and less than or equal to a thickness of the wafer, and a width of the insulating band is less than or equal to a width of the scribe line; S 1020, fabricating an insulating layer on an upper surface of the wafer; S1030, fabricating a plurality of holes on the insulating layer above each of the plurality of chip regions to expose each of the chip regions; S1040, depositing a conductive material in the plurality of holes to form a plurality of bonding pads; and S1050, thinning a back surface of the wafer to obtain a packaged discrete device for each of the chip regions.

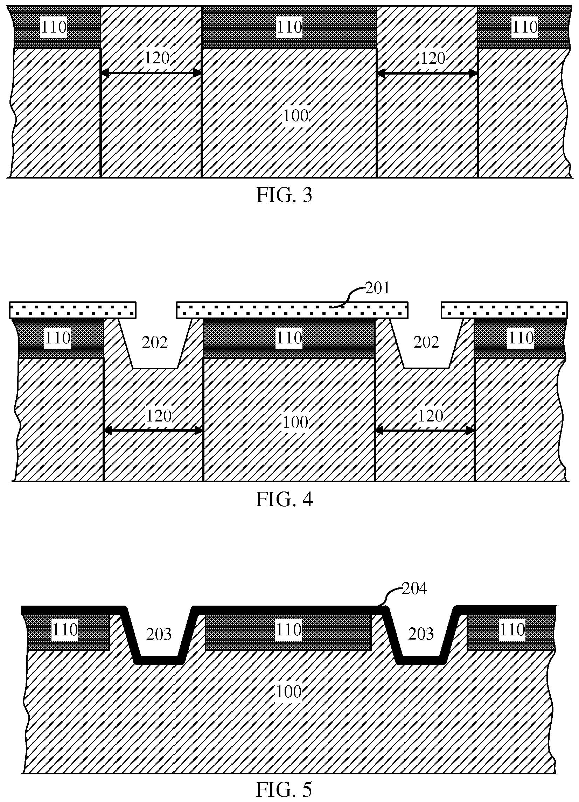

It should be understood that a wafer in an embodiment of the present application may be the wafer 100 shown in FIGS. 2 and 3, FIG. 2 shows a top view of a wafer 100 according to an embodiment of the present application, and FIG. 3 shows a cross-sectional view of a wafer 100 according to an embodiment of the present application. The wafer 100 includes a plurality of independent chip regions 110 that may be uniformly arranged as shown in FIG. 2, that is, horizontal distances between two adjacent chip regions 110 in a horizontal direction are the same, vertical distances between two adjacent chip regions 110 in a vertical direction are the same, and the horizontal distances and the vertical distances are the same. Optionally, the chip regions 110 on the wafer 100 may also be nonuniformly arranged, for example, horizontal distances are different, or vertical distances are different, or the horizontal distances differ from the vertical distances, and the embodiment of the present application is not limited thereto.

In addition, a thickness of each of the chip regions 110 on the wafer 100 is less than a thickness of the wafer 100. A thickness of each of the chip regions 110 may be set according to a thickness of a chip to be packaged or a type of a chip to be packaged. The thickness of the chip region 110 in the embodiment of the present application refers to an effective thickness of the chip region 100 in practical application.

A region on the wafer 100 other than the chip region 110 is a scribe line 120, that is, the scribe line 120 is a region between two adjacent chip regions 110. As shown in FIG. 2, the scribe line 120 is grid-shaped, and correspondingly, an insulating band fabricated on the scribe line 120 of the wafer 100 is also grid-shaped.

In the embodiment of the present application, the insulating band is fabricated on the scribe line 120 of the wafer 100. Optionally, the insulating band may be fabricated in various ways, and the chip may be packaged according to different insulating bands. Specifically, fabricating the insulating band may include fabricating a trench on the scribe line 120 and depositing an insulating material in the trench to form the insulating band; or by electrochemical etching or other manners, converting a portion of a region of the scribe line 120 into a porous silicon region or an insulating region made of other materials as an insulating band.

Different embodiments of a chip packaging method according to an embodiment of the present application will be respectively described below with reference to FIGS. 4 to 26 according to different manners of fabricating an insulating band.

Optionally, as one embodiment, a first embodiment of the chip packaging method 1000 of Embodiment 1 will be described in detail with reference to FIGS. 4 to 8. Specifically, the first embodiment includes the following steps (steps 11.1-11.5).

Step 11.1, a trench 202 surrounding each of chip regions 110 is fabricated on a scribe line 120. A depth of the trench is greater than a thickness of the chip region 110 and less than a thickness of the wafer 100, and a width of the trench 202 is less than or equal to a width of the scribe line 120, where the trench 202 may be as shown in FIG. 4.

It should be understood that, as shown in FIG. 4, a side section of the trench 202 being a trapezoid whose lower part is narrower and upper part is wider (also referred to as an inverted trapezoid) is taken as an example. Optionally, a side section of the trench 202 may be any pattern, including regular and irregular patterns, for example, the trench 202 may be a rectangle with an upper width equal to a lower width, or may also be an arc, and the embodiment of the present application is not limited thereto.

In this embodiment, the width of the trench 202 may refer to a maximum width of the side section of the trench 202; for example, as shown in FIG. 4, a maximum width of the trench is an uppermost opening of the trench 202, and the width is less than or equal to the width of the scribe line 120.

It should be understood that the trench 202 may be fabricated on the scribe line 120 by means of at least one of dry etching, wet etching and mechanical cutting. Optionally, as an embodiment, as shown in FIG. 4, a first protective layer 201 may be first deposited on an upper surface of a wafer 100, for example, by means of plasma assisted deposition, a silicon nitride layer is deposited on a front surface of the wafer 100 as the first protective layer 201; a first window that surrounds the chip region 110 is fabricated on a corresponding first protective layer above the scribe line 120, for example, a window is opened by photolithography in a region located above the scribe line 120 in the first protective layer 201; the wafer 100 is etched in a first chemical solution to obtain the trench 202 surrounding each of the chip regions 110 at the first window, where the first chemical solution may be any one of a potassium hydroxide solution, a sodium hydroxide (NaOH) solution, a tetramethylammonium hydroxide (TMAH) solution, and a mixed solution containing hydrofluoric acid and nitric acid (HNA), or the first chemical solution may be other solutions capable of etching. For example, the wafer 100 is etched in a potassium hydroxide solution to obtain an inverted trapezoidal trench 202 as shown in FIG. 4. Finally, the first protective layer 201 is removed after the trench 202 is formed.

Step 11.2, an insulating material is deposited on an inner surface of the trench 202, and the trench deposited the insulating material may form an insulating band 203; a depth of the trench deposited the insulating material is greater than or equal to a thickness of the chip region 110; at the same time, an insulating layer 204 is also fabricated on an upper surface of the wafer 100, for example, an insulating material is deposited on the upper surface of the wafer 100 to form the insulating layer 204.

Specifically, as for depositing the insulating material in the embodiment of the present application, for example, depositing the insulating material to form the insulating band 203, for another example, depositing the insulating material to form the insulating layer 204, all of these may be performed by at least one of the following manners, and various processes of depositing the insulating material may be the same or different. For example, the insulating material includes a silicon nitride or a silicon oxide grown by physical vapor deposition (Physical Vapor Deposition, PVD) or chemical vapor deposition (Chemical Vapor Deposition, CVD), such as unpoded silicon glass (Undoped Silicon Glass, USG), or a silicon oxide converted by tetraethyl orthosilicate (Tetraethyl Orthosilicate, TEOS), or the like. For another example, the insulating material includes various types of sprayed or spin-coated polymers, such as polyimide (Polyimide), parylene (Parylene), benzocyclobutene (BCB) or the like; alternatively, the insulating material also includes a spin on glass (spin on glass, SOG), that is, amorphous phase silicon oxide obtained by spin-coating or spraying a silicide-containing solution on a silicon wafer, then performing heating to remove a solvent, and conducting curing. One or more layers of the insulating material may be deposited. The insulating band 203 and the insulating layer 204 may be simultaneously formed in a same process.

In the embodiment of the present application, the insulating material is deposited in the trench 202 to form the insulating band 203, the insulating material only covers the surface of the trench to form a concave insulating layer having a certain thickness, and a depth of a concave portion of the concave insulating layer is still greater than or equal to the thickness of the chip region 110.

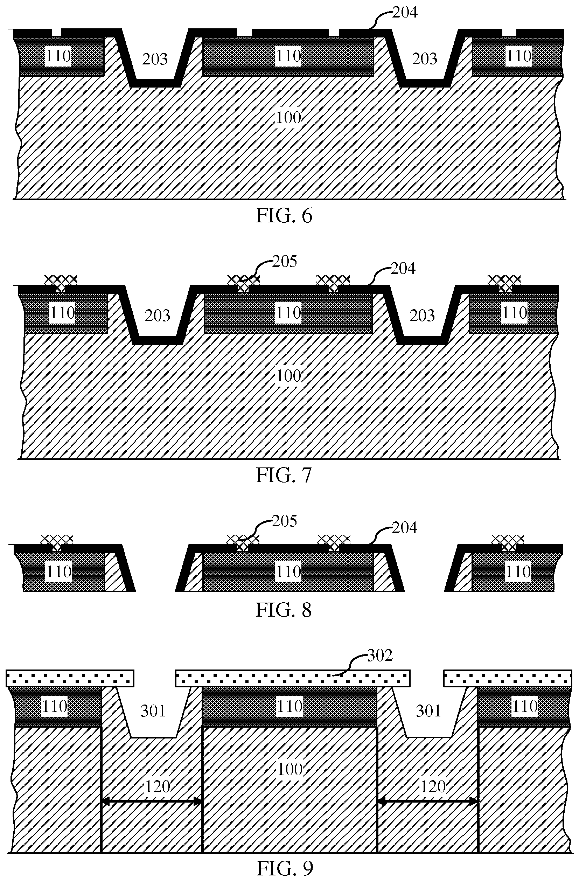

Step 11.3, a plurality of holes are fabricated on the insulating layer 204 above each of the plurality of chip regions 110 to expose each of the chip regions 110, and as shown in FIG. 6, fabricating two holes above each of the chip regions 110 is taken as an example.

Taking any one of chip regions on the wafer 100 as an example, assuming that the chip region is an intermediate chip region 110 as shown in FIG. 6, two holes are opened in the insulating layer 204 corresponding to an upper surface of the chip region 110, for example, the two holes may be opened by photolithography, and the embodiment of the present application is not limited thereto.

Step 11.4, a conductive material is deposited in each of holes on the insulating layer 204, and then patterned to form a plurality of bonding pads 205 of each of the chip regions 110, and the plurality of bonding pads 205 are located on a same side of the chip region 110. For example, two bonding pads 205 formed on a same side of each of the chip regions 110 are taken as an example, as shown in FIG. 7.

It should be understood that a manner of depositing the conductive material in the embodiment of the present application may include at least one of the following: for example, atomic layer deposition (atomic layer deposition, ALD), PVD, metal-organic chemical vapor deposition, evaporation, electroplating, or the like. Correspondingly, the conductive material may be heavily doped polysilicon, or a carbon-based material, or various metals such as aluminum, tungsten, copper, and the like, and may also be a low resistivity compound such as titanium nitride, or a combination of the foregoing several conductive materials, and the embodiment of the present application is not limited thereto.

It should be understood that the conductive material is deposited in each of the holes on the insulating layer 204 to form the plurality of bonding pads 205, and the number of holes corresponding to any one of the chip regions 110 is greater than or equal to the number of bonding pads, that is, in the plurality of holes corresponding to one chip region 110, there may be a case where the conductive material is deposited in two or more holes to form one bonding pad.

Step 11.5, a back surface of the wafer 100 is thinned to separate the plurality of chip regions 110 to obtain a packaged discrete device for each of the chip regions 110. As shown in FIG. 8, a middle portion of FIG. 8 shows a complete discrete device including the chip region 110.

Specifically, the thinning manner in the embodiment of the present application may include at least one of lapping, grinding, chemical mechanical polish, chemical mechanical polish, CMP), dry polishing (dry polishing), electrochemical etching (electrochemical etching), wet etching (wet etching), plasma assisted chemical etching (plasma assisted chemical etching, PACE), atmospheric downstream plasma etching (atmospheric downstream plasma etching, ADPE), or the like.

It should be understood that as shown in FIG. 8, since the depth of the insulating band 203 is greater than or equal to the thickness of the chip region 110, the back surface of the wafer 100 is thinned to an effective thickness portion of a bottom layer of the chip region 110, and at the same time a bottom portion of the insulating band 203 between the chip regions 110 is also removed, that is, the wafer 100 is simultaneously divided into a plurality of discrete devices, which does not need to further cut a scribe line region, thereby reducing processing steps.

Optionally, as one embodiment, a second embodiment of the chip packaging method 1000 will be described in detail below with reference to FIGS. 9 to 14. Specifically, the second embodiment includes the following steps (steps 12.1-12.6).

Step 12.1, a trench 301 surrounding each of chip regions is fabricated on a scribe line 120, where a depth of the trench 301 is greater than or equal to a thickness of a surrounded chip region 110 and less than or equal to a thickness of a wafer 100, as shown in FIG. 9.

It should be understood that the trench 301 is similar to the trench 202 in step 11.1, for example, a shape of a side section of the trench 301 and/or a fabrication method of the trench 301 may adopt contents of the trench 202 as described in step 11.1, which will not be repeatedly described here. A protective layer 302 in FIG. 9 is equivalent to the first protective layer 201 shown in FIG. 4.

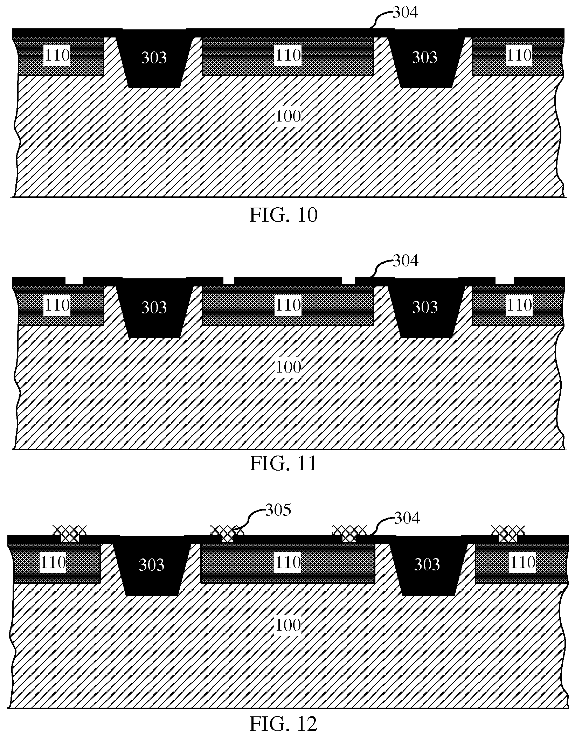

Step 12.2, an insulating material is deposited inside the trench 301 to form an insulating band 303; and an insulating layer 304 is fabricated on an upper surface of the wafer 100, as shown in FIG. 10.

Specifically, the insulating layer 304 may be formed by depositing an insulating material on the upper surface of the wafer 100.

It should be understood that a process of depositing an insulating material in the trench 301 and/or depositing an insulating material on a surface of the wafer 100 may adopt the manner and the material of depositing the insulating material as described in step 11.2, which will not be described repeatedly here.

As shown in FIG. 10, the insulating material is deposited inside the trench 301 to form the insulating band 303, and the trench 301 is filled up with the insulating material to form the insulating band 303 that is filled up with the trench 301, or the trench 301 is filled with a thicker insulating material, and a depth of the trench filled with the insulating material is less than a thickness of the chip region 110; in some cases, the depth may be 0, as shown in FIG. 10, the surface of the insulating band 303 may be flush with the surface of the wafer 100.

Step 12.3, a plurality of holes are fabricated on the insulating layer 304 above each of the plurality of chip regions 110 to expose each of the chip regions 110, for example, two holes are fabricated above each of the chip regions 110, as shown in FIG. 11.

It should be understood that step 12.3 is similar to step 11.3, which will not be repeatedly described here.

Step 12.4, a conductive material is deposited in the plurality of holes to form a plurality of bonding pads 305; for example, as shown in FIG. 12, two bonding pads 305 are correspondingly formed for each of the chip regions 110.

It should be understood that step 12.4 is similar to step 11.4, which will not be repeatedly described here.

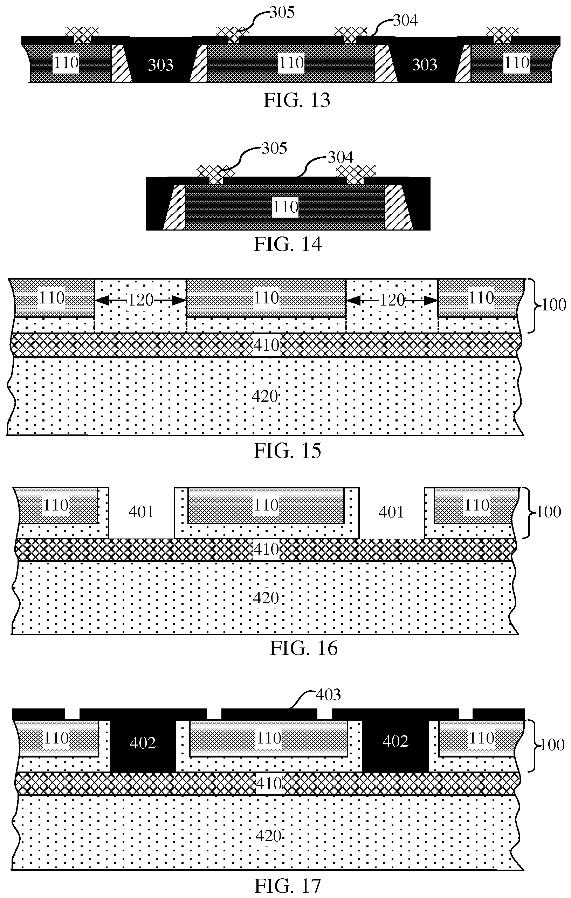

Step 12.5, a back surface of the wafer 100 is thinned to expose the insulating band 303, as shown in FIG. 13.

It should be understood that the manner of thinning the wafer 100 may be similar to that in step 11.5, which will not be repeatedly described here.

Specifically, as shown in FIG. 13, since the insulating band 303 is thicker, the wafer 100 may be thinned to expose a bottom portion of the insulating band 303, and the back surface of the wafer 100 is thinned to an effective thickness portion of a bottom layer of the chip region 110 to obtain the wafer 100 as shown in FIG. 13.

In step 12.6, dicing is performed along the insulating band 303 to obtain a packaged discrete device for each of the chip regions 110, as shown in FIG. 14.

Specifically, since the insulating band 303 is thicker, after the back surface of the wafer 100 is thinned to the effective thickness portion of the bottom layer of the chip region 110, adjacent chip regions 110 are still connected by the insulating band 303, and the insulating band 303 may be longitudinally cut by dicing technology to obtain the packaged discrete device of the chip region 110 as shown in FIG. 14.

Optionally, as one embodiment, a third embodiment of the chip packaging method 1000 will be described in detail below with reference to FIGS. 15 to 19. Specifically, as shown in FIG. 15, an SOI (Silicon On Insulator) substrate used in the third embodiment includes three layers, where an intermediate layer is an insulating layer 410, an upper layer may be regarded as the wafer 100 including a chip region 110 shown in FIG. 3, that is, the chip region 110 of the wafer 100 is located above the insulating layer 410, and a material of a lower layer 420 may be the same as or different from a material of the upper layer of the wafer 100. The third embodiment includes the following steps (steps 13.1-13.6).

Step 13.1, a trench 401 surrounding each of chip regions 110 is fabricated on a scribe line 120. A depth of the trench is greater than or equal to a thickness of the chip region 110, but the depth of the trench 402 does not exceed an intermediate insulating layer 410, that is, the trench 401 exposes the insulating layer 410 but does not penetrate through the insulating layer 410; a width of the trench 401 is less than or equal to a width of the scribe line 120, where the trench 401 may be as shown in FIG. 16.

It should be understood that the trench 401 is similar to the trench 202 in step 11.1, for example, a shape of a side section of the trench 401, and/or a fabrication method of the trench 401 may adopt contents of the trench 202 as described in step 11.1, which will not be repeatedly described here.

Step 13.2, an insulating material is deposited on an inner surface of the trench 401 to form an insulating band 402; at the same time, an insulating layer 403 is also fabricated on an upper surface of the wafer 100, for example, the insulating material is deposited on the upper surface of the wafer 100 to form the insulating layer 403, such as the insulating band 402 and the insulating layer 403 (excluding holes in the insulating layer 403) as shown in FIG. 17.

It should be understood that a process of depositing an insulating material in the trench 401 and/or depositing an insulating material on a surface of the wafer 100 may adopt the manner and the material of depositing the insulating material as described in step 11.2, which will not be described repeatedly here.

As shown in FIG. 17, to deposit the insulating material inside the trench 401 to form the insulating band 402, may be to fill up the trench 401 with the insulating material; since a depth of the trench 401 is greater than a thickness of the chip region 110, correspondingly, a thickness of the insulating band 402 is also greater than a thickness of the chip region 110. Alternatively, if the trench 401 is filled with a thicker insulating material but not entirely filled, a depth of the trench filled with the insulating material is less than a thickness of the chip region 110.

Step 13.3, a plurality of holes are fabricated on the insulating layer 403 above each of the plurality of chip regions 110 to expose each of the chip regions 110, for example, two holes are fabricated for each of the chip regions 110, as shown in FIG. 17.

It should be understood that step 13.3 is similar to step 11.3, which will not be repeatedly described here.

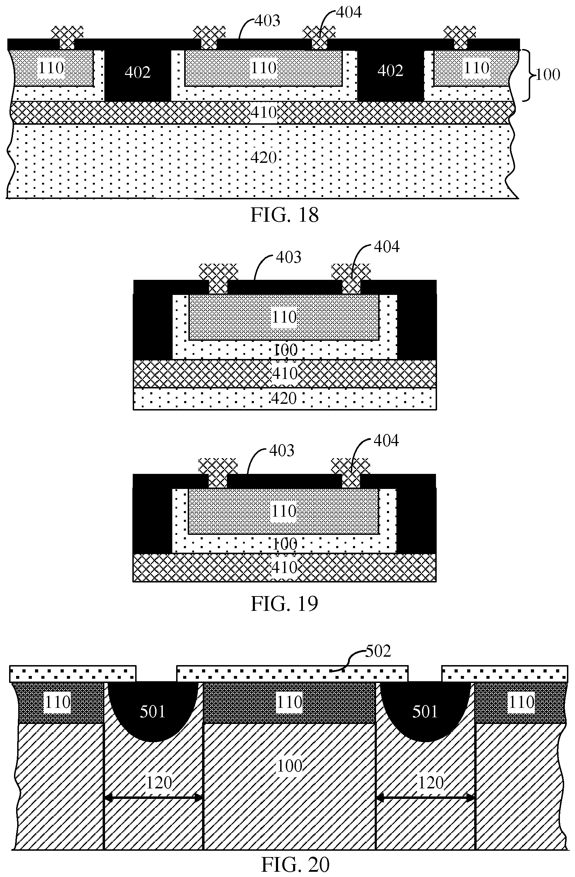

Step 13.4, a conductive material is deposited in the plurality of holes to form a plurality of bonding pads 404; for example, as shown in FIG. 18, two bonding pads 404 are correspondingly formed for each of the chip regions 110.

It should be understood that step 13.4 is similar to step 11.4, which will not be repeatedly described here.

Step 13.5, a back surface of an SOI substrate is thinned to remove a lower layer 420 and expose an intermediate insulating layer 410, as shown in a lower figure of FIG. 19; alternatively, a lower layer 420 of an SOI substrate is thinned and the lower layer 420 with a certain thickness is retained, as shown in an upper figure in FIG. 19.

It should be understood that the manner of thinning the wafer 100 may be similar to that in step 11.5, which will not be repeatedly described here.

Step 13.6, dicing is performed along the insulating band 402 to obtain a packaged discrete device for each of the chip regions 110, as shown in FIG. 19.

Specifically, as shown in FIG. 18, since the insulating band 402 is thicker, after the wafer 100 is thinned, adjacent chip regions 110 are still connected by the insulating band 402, the insulating band 402 may be longitudinally cut by dicing technology to obtain the packaged discrete device of the chip region 110 as shown in FIG. 19.

Optionally, as one embodiment, a fourth embodiment of the chip packaging method 1000 will be described in detail below with reference to FIGS. 20 to 26. Specifically, the fourth embodiment includes the following steps (steps 14.1-14.6).

Step 14.1, a region surrounding each of chip regions 110 on a scribe line 120 is converted into a porous silicon region by electrochemical etching or the like, and the porous silicon region forms an insulating band 501. A thickness of the insulating band 501 is greater than or equal to a thickness of the chip region 110 and less than or equal to a thickness of a wafer 100, and a width of the insulating band 501 is less than or equal to a width of the scribe line 120, where the insulating band 501 may be as shown in FIG. 20.

Specifically, a portion of monocrystalline silicon on the scribe line 120 of the wafer 100 may be converted into porous silicon by electrochemical etching or other manners. The porous silicon is preferably mesoporous porous silicon with a pore diameter ranging from 2 to 50 nm. A side section of the insulating band 501 made of porous silicon may be any shape, for example, it may be arc-shaped as shown in FIG. 20, but the embodiment of the present application is not limited thereto.

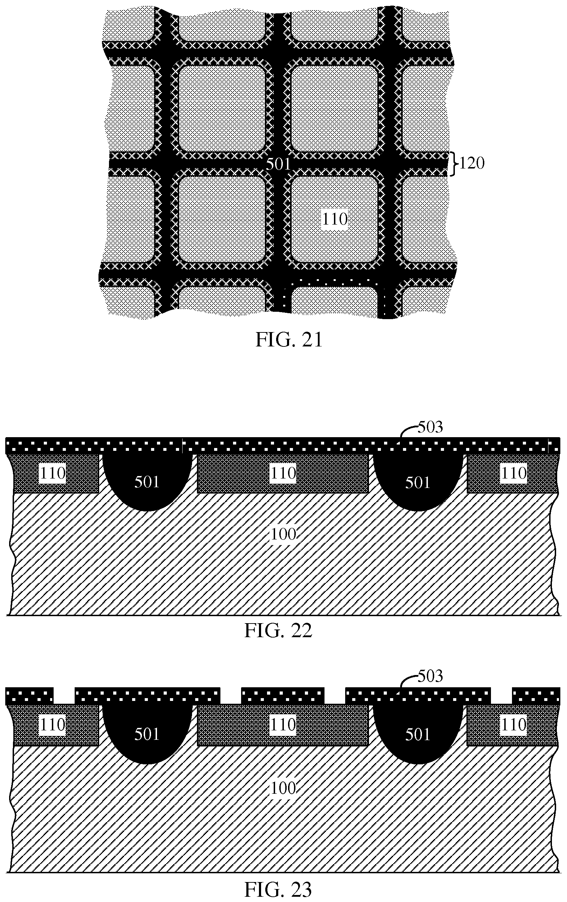

Optionally, as an embodiment, as shown in FIG. 20, a second protective layer 502 is first deposited on an upper surface of the wafer 100, for example, by means of plasma assisted deposition, a layer of fluoropolymer (fluoropolymer) is deposited on a front surface of the wafer 100 as the second protective layer 502; a second window that surrounds the chip region 110 is fabricated on a corresponding second protective layer above the scribe line 120, for example, a window is opened in the scribe line 202 region by photolithography; the wafer 100 is etched in a second chemical solution, to obtain the porous silicon region surrounding each of the chip regions 110 at the second window, that is, the insulating band 501; for example, the second chemical solution may be a mixed solution containing hydrofluoric acid, that is, the wafer 100 is placed in a solution containing hydrofluoric acid, to obtain the porous silicon layer as shown in FIG. 20 by electrochemical etching; and finally, the second protective layer 502 is removed to obtain the insulating band 501 as shown in FIG. 21. FIG. 21 is a top view of the wafer 100, and a black region on an intermediate grid-shaped scribe lines 120 is the insulating band 501.

In this embodiment, a width of the insulating band 501 may refer to a maximum width on a side section of the insulating band 501; for example, as shown in FIG. 20, the maximum width of the insulating band 501 is at an uppermost opening of the insulating band 501, that is, a diameter of a circle where the insulating band 501 is located, and the width is less than or equal to the width of the scribe line 120.

Step 14.2, an insulating layer 503 is fabricated on an upper surface of a wafer 100, as shown in FIG. 22.

Specifically, the insulating layer 503 may be formed by depositing an insulating material on the upper surface of the wafer 100.

It should be understood that a process of depositing an insulating material on a surface of the wafer 100 may adopt the manner and material of depositing the insulating material as described in step 11.2, which will not be described repeatedly here.

Step 14.3, a plurality of holes are fabricated on the insulating layer 503 above each of the plurality of chip regions 110 to expose each of the chip regions 110, for example, two holes are fabricated for each of the chip regions 110, as shown in FIG. 23.

It should be understood that step 14.3 is similar to step 11.3, which will not be repeatedly described here.

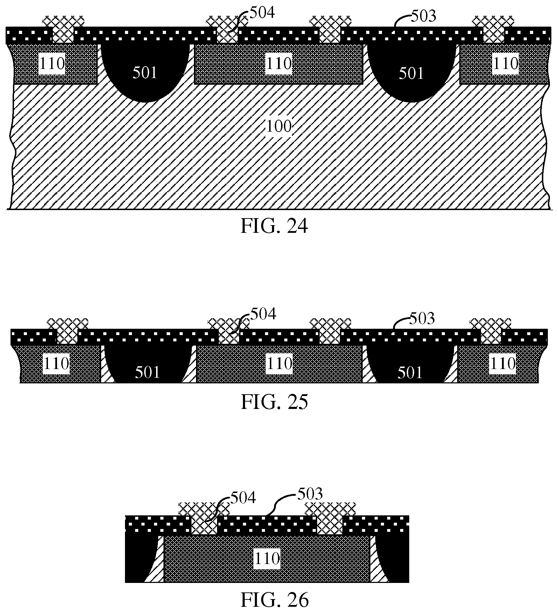

Step 14.4, a conductive material is deposited in the plurality of holes to form a plurality of bonding pads 504; for example, as shown in FIG. 24, two bonding pads 504 are correspondingly formed for each of the chip regions 110.

It should be understood that step 14.4 is similar to step 11.4, which will not be repeatedly described here.

Step 14.5, a back surface of the wafer 100 is thinned to expose the insulating band 501, as shown in FIG. 25.

It should be understood that the manner of thinning the wafer 100 may be similar to that in step 11.5, which will not be repeatedly described here.

Specifically, as shown in FIG. 25, since the insulating band 501 is thicker, the wafer 100 may be thinned to expose a bottom portion of the insulating band 501, and the back surface of the wafer 100 is thinned to an effective thickness portion of a bottom layer of the chip region 110 to obtain the wafer 100 as shown in FIG. 25.

Step 14.6, dicing is performed along the insulating band 501 to obtain a packaged discrete device for each of the chip regions 110, as shown in FIG. 26.

Specifically, since the insulating band 501 is thicker, after the back surface of the wafer 100 is thinned to the effective thickness portion of the bottom layer of the chip region 110, adjacent chip regions 110 are still connected by the insulating band 501, the insulating band 501 may be longitudinally cut by dicing technology to obtain the packaged discrete device of the chip region 110 as shown in FIG. 26.

The first embodiment of the chip packaging method 1000 in the Embodiment of the present application will be described in detail below with reference to a specific embodiment.

Step 15.1, a wafer 100 obtained by processing a silicon wafer with a crystal orientation (100) is selected, where the wafer 100 includes a plurality of chip regions 110 and a grid-shaped scribe line 120. A top view of the wafer is shown in FIG. 2, and a cross-sectional view of the wafer is shown in FIG. 3. A thickness of the chip region 110 is less than a thickness of the wafer 100.

Step 15.2, as shown in FIG. 4, a layer of silicon nitride 201 is deposited on an upper surface of the wafer 100 by plasma assisted deposition, and a window is opened in a region corresponding to the scribe line 120 by photolithography. The wafer 100 is etched in a potassium hydroxide solution to obtain an inverted trapezoidal trench 202 as shown in FIG. 4. A maximum width of the trench 202 is less than a minimum width of the scribe line 120. A depth of the trench 202 ranges from tens to hundreds of microns, which is less than the thickness of the wafer 100 but greater than the thickness of the chip region 110. Finally, the silicon nitride 201 is removed.

Step 15.3, by means of plasma enhanced chemical vapor deposition (plasma enhanced chemical vapor deposition, PECVD), a layer of USG with a thickness of 2 microns is deposited on a front surface of the wafer 100 and an inner wall of the trench 202 as the insulating layer 204 and the insulating band 203 respectively, as shown in FIG. 5. Next, two windows are opened in a region of the insulating layer 204 corresponding to the chip region 110 by photolithography, as shown in FIG. 6.

Step 15.4, a layer of aluminum with a thickness of 3 microns, a layer of nickel with a thickness of 200 nanometers, and a layer of gold with a thickness of 100 microns are deposited on the front surface of the wafer 100 by PVD, and a bonding pad 505 of the chip is patterned and fabricated by photolithography, as shown in FIG. 7.

Step 15.5, the wafer 100 is thinned to an effective thickness of the chip region 110 by mechanical grinding in combination with dry etching, as shown in FIG. 8, to obtain discrete devices whose side walls are covered with an insulating material.

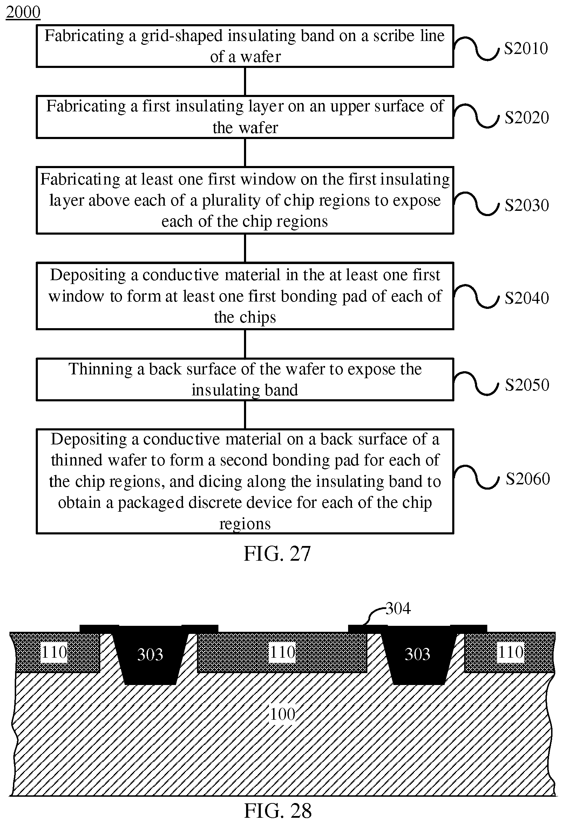

The chip packaging method 1000 according to the embodiment of the present application is described in detail above with reference to FIGS. 1 to 26, the bonding pads of the discrete device of the chip obtained by the method 1000 are located on the same side, and a chip packaging method 2000 according to another embodiment of the present application will be described below with reference to FIGS. 27 to 37.

FIG. 27 shows a schematic flowchart of a chip packaging method 2000 according to Embodiment 2 of the present application. As shown in FIG. 27, the method 2000 includes: S2010, fabricating an insulating band on a scribe line of a wafer, where a front surface of the wafer is provided with a plurality of independent chip regions, a portion between any two adjacent chip regions of the plurality of chip regions is the scribe line, and between the any two adjacent chip regions, a depth of the insulating band is greater than or equal to a thickness of the chip region and less than or equal to a thickness of the wafer, and a width of the insulating band is less than or equal to a width of the scribe line; S2020, fabricating a first insulating layer on an upper surface of the wafer; S2030, fabricating at least one first window on the first insulating layer above each of a plurality of chip regions to expose each of the chip regions; S2040, depositing a conductive material in the at least one first window to form at least one first bonding pad of each of the chips; S2050, thinning a back surface of the wafer to expose the insulating band; and S2060, depositing a conductive material on a back surface of a thinned wafer to form a second bonding pad for each of the chip regions, and dicing along the insulating band to obtain a packaged discrete device for each of the chip regions.

It should be understood that the wafer in the method 2000 may be the same as the wafer 100 in the method 1000, as shown in FIGS. 2 and 3, which will not be repeatedly described here. Correspondingly, the manner of forming the first bonding pad may refer to the foregoing methods in the first to fourth embodiments, certainly, the number and size of the corresponding holes formed in the chip region may also be varied according to requirements of the number and size of the bonding pads.

In the embodiment of the present application, the insulating band is fabricated on the scribe line 120 of the wafer 100. Optionally, the insulating band may be fabricated in various ways, and the chip may be packaged according to different insulating bands. Specifically, fabricating the insulating band may include fabricating a trench on the scribe line 120 and depositing an insulating material in the trench to form the insulating band; or by electrochemical etching or other manners, converting a portion of a region of the scribe line 120 into a porous silicon region or an insulating region made of other materials as an insulating band.

In the embodiment of the present application, in the S2060 of the method 2000, the depositing the conductive material on the back surface of the thinned wafer to form the second bonding pad for each of the chip regions may include: depositing an insulating material on the back surface of the thinned wafer to form a second insulating layer; fabricating, on the second insulating layer below each of the chip regions, at least one second window to expose each of the chip regions; and depositing a conductive material in the at least one second window to form the at least one second bonding pad of each of the chips.

Different embodiments of a chip packaging method according to an embodiment of the present application will be respectively described below with reference to FIGS. 28 to 37 according to different manners of fabricating an insulating band and different manners of fabricating the second bonding pad.

Optionally, as a first embodiment of Embodiment 2, the first embodiment of chip packaging method 2000 will be described in detail with reference to FIGS. 28 to 32. Specifically, the first embodiment of the method 2000 includes the following steps (steps 21.1-21.7).

Step 21.1 is the same as step 12.1, which will not be repeatedly described here.

Step 21.2 is the same as step 12.2, which will not be repeatedly described here.

Step 21.3, at least one first window is formed on an insulating layer 304 above each of chip regions 100 to expose each of the chip regions 110; for example, one first window is correspondingly fabricated for each of the chip regions 110, as shown in FIG. 28.

It should be understood that a size of the first window on the insulating layer 304 is not limited here. For example, as shown in FIG. 28, the first window may be larger.

It should be understood that a process of fabricating any one of first windows on the insulating layer 304 may be the same as a process of fabricating any one of a plurality of holes in step 12.3, which will not be repeatedly described here.

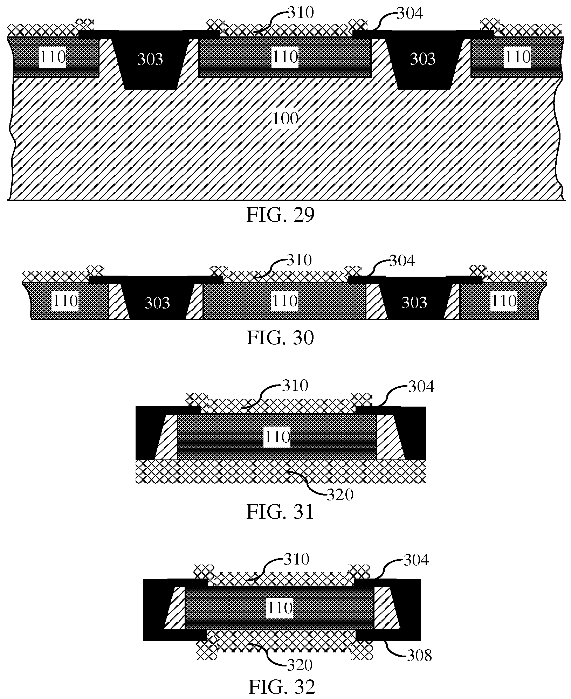

Step 21.4, a conductive material is deposited in the at least one first window to form at least one first bonding pad 310 of each of the chip regions; for example, as shown in FIG. 29, each of the chip regions corresponding to one first bonding pad 310 is taken as an example.

It should be understood that a process of depositing the conductive material to form any one of the first bonding pads 310 may be the same as a process of fabricating any one of the bonding pads in step 11.4, which will not be repeatedly described here.

It should be understood that the number of the at least one first window is greater than or equal to the number of the at least one first bonding pad 310, that is, there may be a case where two or more first windows form one first bonding pad 310 correspondingly.

Step 21.5, a back surface of a wafer 100 is thinned to expose an insulating band 303, as shown in FIG. 30.

It should be understood that step 21.5 is the same as step 12.5, which will not be repeatedly described here.

Step 21.6, a conductive material is deposited on a back surface of a thinned wafer 100 to form a second bonding pad 320 for each of the chip regions, as shown in FIG. 31. Alternatively, a process of fabricating the second bonding pad 320 on the back surface of the thinned wafer 100 is the same as that of the first bonding pad 310, that is, an insulating material is deposited on the thinned wafer 100 to form a second insulating layer 308; at least one second window is fabricated on the second insulating layer 308 below each of the chip regions 110 to expose each of the chip regions 110; and a conductive material is deposited in the at least one second window to form at least one second bonding pad 320 for each of the chip regions. For example, as shown in FIG. 32, fabricating a second window under each of the chip regions 110 to form a second bonding pad 320 is taken as an example.

It should be understood that an alternative manner and material for forming the second bonding pad 320 by depositing the conductive material may be the same as that of the first bonding pad 310, which will not be repeatedly described here.

Step 21.7, dicing is performed along the insulating band 303 to obtain the packaged discrete device for each of the chip regions 110, as shown in FIGS. 31 and 32.

It should be understood that step 21.7 is the same as step 12.6, which will not be repeatedly described here.

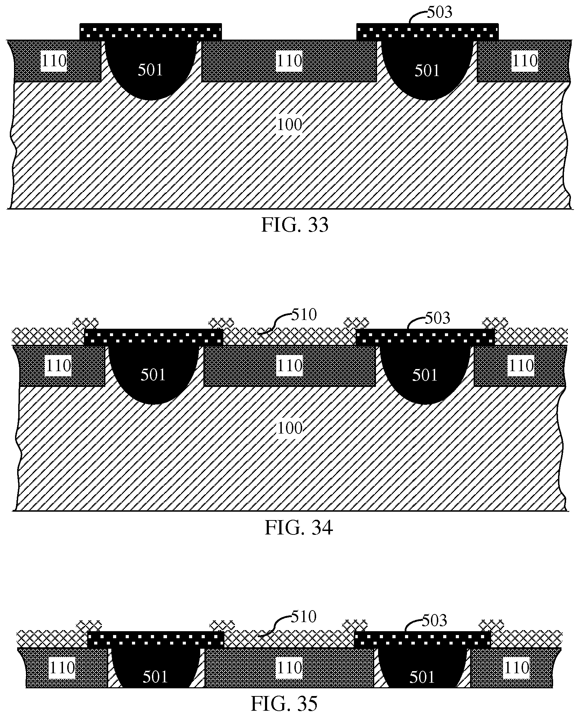

Optionally, as one embodiment, a second embodiment of the chip packaging method 2000 will be described in detail with reference to FIGS. 33 to 37. Specifically, the second embodiment of the method 2000 includes the following steps (steps 22.1-22.7).

Step 22.1 is the same as step 14.1, which will not be repeatedly described here.

Step 22.2 is the same as step 14.2, which will not be repeatedly described here.

Step 22.3, at least one first window is fabricated on an insulating layer 503 above each of plurality of chip regions 11 to expose each of the chip regions 110; for example, one first window is correspondingly fabricated for each chip region 110, as shown in FIG. 33.

It should be understood that a size of the first window on the insulating layer 503 is not limited here. For example, as shown in FIG. 33, the first window may be larger.

It should be understood that a process of fabricating any one of first windows on the insulating layer 503 may be the same as a process of fabricating any one of a plurality of holes in step 14.3, which will not be repeatedly described here.

Step 22.4, a conductive material is deposited in the at least one first window to form at least one first bonding pad 510 of each of the chip regions; for example, as shown in FIG. 34, each of the chip regions corresponding to one first bonding pad 510 is taken as an example.

It should be understood that a process of depositing the conductive material to form any one of the first bonding pads 51 may be the same as a process of fabricating any one of the bonding pads in step 11.4, which will not be repeatedly described here.

It should be understood that the number of the at least one first window is greater than or equal to the number of the at least one first bonding pad 510, that is, there may be a case where two or more first windows form one first bonding pad 510 correspondingly.

Step 22.5, a back surface of a wafer 100 is thinned to expose an insulating band 501, as shown in FIG. 35.

It should be understood that step 22.5 is the same as step 14.5, which will not be repeatedly described here.

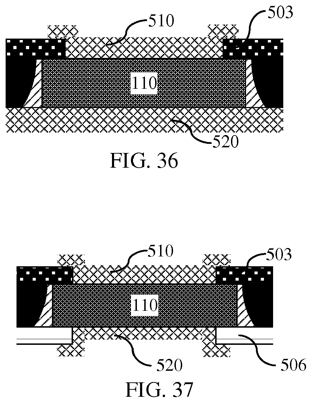

Step 22.6, a conductive material is deposited on a back surface of a thinned wafer 100 to form a second bonding pad 520 for each of the chip regions, as shown in FIG. 36. Alternatively, a process of fabricating the second bonding pad 520 on the back surface of the thinned wafer 100 is the same as that of the first bonding pad 510, that is, an insulating material is deposited on the thinned wafer 100 to form a second insulating layer 506; at least one second window is fabricated on the second insulating layer 506 below each of the chip regions 110 to expose each of the chip regions 110; and a conductive material is deposited in the at least one second window to form at least one second bonding pad 520 for each of the chip regions. For example, as shown in FIG. 37, fabricating a second window under each of the chip regions 110 to form a second bonding pad 520 is taken as an example.

It should be understood that an alternative manner and material for forming the second bonding pad 520 by depositing the conductive material may be the same as that of the first bonding pad 510, which will not be repeatedly described here.

Step 22.7, dicing is performed along the insulating band 501 to obtain the packaged discrete device for each of the chip regions 110, as shown in FIGS. 36 and 37.

It should be understood that step 21.7 is the same as step 14.6, which will not be repeatedly described here.

A second embodiment of the chip packaging method 2000 in the Embodiment of the present application will be described in detail below with reference to a specific embodiment.

Step 23.1, a wafer 100 obtained by processing a P-type heavily doped silicon wafer is selected, where the wafer 100 includes a plurality of chip regions 110 and a grid-shaped scribe line 120. A thickness of the chip region 110 is less than a thickness of the wafer 100, as shown in FIGS. 2 and 3.

Step 23.2, as shown in FIG. 20, a layer of fluoropolymer (fluoropolymer) 502 is deposited on a front surface of the wafer 100 by plasma assisted deposition, and a window is opened in a region corresponding to the scribe line 120 by photolithography. The wafer 100 is etched in a solution containing hydrofluoric acid by electrochemical etching to obtain a porous silicon layer 501 as shown in FIG. 20. A maximum width of the porous silicon layer 501 is less than a minimum width of the scribe line 120. A depth of the porous silicon layer 501 ranges from tens to hundreds of microns, which is less than the thickness of the wafer 100 but greater than the thickness of the chip region 120. Finally, the fluoropolymer 502 is removed to obtain a top view of the wafer as shown in FIG. 21.

Step 23.3, by means of PECVD, a layer of USG with a thickness of 2 microns is deposited on the front surface of the wafer 100 as an insulating layer 503, as shown in FIG. 22. Next, a window is opened in the insulating layer 503 above the chip region 110 by photolithography, as shown in FIG. 33.

Step 23.4, a layer of aluminum with a thickness of 3 microns, a layer of nickel with a thickness of 200 nanometers, and a layer of gold with a thickness of 100 microns are deposited on the front surface of the wafer by PVD, and a bonding pad 510 of the chip is patterned and fabricated by photolithography, as shown in FIG. 34.

Step 23.5, the wafer is thinned to an effective thickness of the chip region 110 by mechanical grinding and polishing, as shown in FIG. 35.

Steps 23.6 and 23.7: steps 23.3 and 23.4 are repeated, that is, an insulating layer 506 and a back bonding pad 520 are fabricated on a back surface of a thinned wafer 100, as shown in FIG. 37.

Step 23.8, dicing is performed along the scribe line to obtain discrete devices whose side walls are made of porous silicon, as shown in FIG. 37.

It should be understood that according to the chip packaging method in the embodiment of the present application, a semiconductor device with side protection is fabricated, including a passive device (a capacitor, an inductor, a resistor, and the like), an energy storage device, or the like.

According to a chip packaging method of an embodiment of the present application, an insulation protection method for a side surface of a wafer-level chip in a semiconductor front-end process is achieved by fabricating a trench surrounding chips and having an insulating material therein, or by fabricating a grid-shaped porous silicon region surrounding chips, so that a step of packaging a single chip at a back end is omitted, cost is lower, and a chip volume is smaller, thereby resolving a contradiction of insulation protection for a side surface of a semiconductor discrete device and complicated packaging procedures at the back end.

It should be understood that in embodiments of the present application, "B corresponding to A" indicates that B is associated with A, and B may be determined based on A. However, it should further be understood that determining B based on A does not mean that B is determined based on A only; and B may also be determined based on A and/or other information.

In addition, the term "and/or" in this specification describes only an association relationship for describing associated objects and represents that three relationships may exist. For example, A and/or B may represent the following three cases: Only A exists, both A and B exist, and only B exists. In addition, the character "/" in this specification generally indicates an "or" relationship between the associated objects.

It should be understood that sequence numbers of the foregoing processes do not mean execution sequences in various embodiments of this application. The execution sequences of the processes should be determined according to functions and internal logic of the processes, and should not be construed as any limitation on the implementation processes of the embodiments of this application.

Persons of ordinary skill in the art may realize that preferred embodiments of the present application have been described in detail above with reference to the accompanying drawings, however, the present application is not limited to the specific details in the foregoing embodiments. Persons skilled in the art may make various simple modifications to the technical solution of the present application within the scope of the technical concept of the present application, and these simple modifications all fall within the scope of protection of the present application.

The foregoing descriptions are merely specific embodiments of the present application, but the protection scope of the present application is not limited thereto, persons skilled in the art who are familiar with the art could readily think of variations or substitutions within the technical scope disclosed by the present application, and these variations or substitutions shall fall within the protection scope of the present application. Therefore, the protection scope of the present application shall be subject to the protection scope of the claims.

## Claims

1. A chip packaging method, comprising:
fabricating an insulating band on a scribe line of a wafer, wherein a front surface of the wafer is provided with a plurality of independent chip regions, a portion between any two adjacent chip regions of the plurality of chip regions is the scribe line, and between the any two adjacent chip regions, a depth of the insulating band is greater than or equal to a thickness of the chip region and less than or equal to a thickness of the wafer, and a width of the insulating band is less than or equal to a width of the scribe line;
fabricating an insulating layer on an upper surface of the wafer;
fabricating a plurality of holes on the insulating layer above each of the plurality of chip regions to expose each chip region;
depositing a conductive material in the plurality of holes to form a plurality of bonding pads; and
thinning a back surface of the wafer to obtain a packaged discrete device for the each chip region.

2. The method according to claim 1, wherein the fabricating the insulating band on the scribe line of the wafer comprises:
fabricating, on the scribe line, a trench surrounding the each chip region; and
depositing an insulating material on an inner surface of the trench, such that the trench deposited the insulating material forms the insulating band; and
the thinning the back surface of the wafer to obtain the packaged discrete device for the each chip region comprises:
thinning the back surface of the wafer to separate the plurality of chip regions to obtain the packaged discrete device for the each chip region.

3. The method according to claim 1, wherein the fabricating the insulating band on the scribe line of the wafer comprises:
fabricating, on the scribe line, a trench surrounding the each chip region, wherein a depth of the trench is greater than or equal to a thickness of a surrounded chip region and less than or equal to a thickness of the wafer;
depositing an insulating material inside the trench to form the insulating band;
the thinning the back surface of the wafer to obtain the packaged discrete device for the each chip region comprises:
thinning the back surface of the wafer to expose the insulating band, and dicing along the insulating band to obtain the packaged discrete device for the each chip region.

4. The method according to claim 2 or 3, wherein the fabricating, on the scribe line, the trench surrounding the each chip region comprises:
fabricating the trench on the scribe line by means of at least one of dry etching, wet etching and mechanical cutting.

5. The method according to claim 4, wherein the fabricating the trench on the scribe line by means of at least one of dry etching, wet etching and mechanical cutting comprises:
depositing a first protective layer on the upper surface of the wafer;
fabricating a first window on the first protective layer above the scribe line; and
etching the wafer in a first chemical solution to obtain the trench at the first window.

6. The method according to claim 5, wherein the depositing the first protective layer on the upper surface of the wafer comprises:
depositing a silicon nitride layer as the first protective layer on the upper surface of the wafer by means of plasma assisted deposition, wherein the first chemical solution is any one of a potassium hydroxide solution, a sodium oxide solution, a tetramethylammonium hydroxide solution and a mixed solution containing hydrofluoric acid and nitric acid.

7. The method according to any one of claims 2 to 6, wherein
the trench is trapezoidal with a bottom width smaller than an upper width; or
the trench is rectangular with a bottom width equal to an upper width.

8. The method according to claim 1, wherein the fabricating the insulating band on the scribe line of the wafer comprises:
converting a portion of the scribe line surrounding the each chip region into a porous silicon region by electrochemical etching, wherein the porous silicon region is the insulating band; and
the thinning the back surface of the wafer to obtain the packaged discrete device for the each chip region comprises:
thinning the back surface of the wafer to expose the insulating band, and dicing along the insulating band to obtain the packaged discrete device for the each chip region.

9. The method according to claim 8, wherein the converting the portion of the scribe line surrounding the each chip region into the porous silicon region by the electrochemical etching comprises:
depositing a second protective layer on the upper surface of the wafer;
fabricating a second window on the second protective layer above the scribe line; and
placing the wafer in a second chemical solution to obtain the porous silicon region at the second window by the electrochemical etching.

10. The method according to claim 9, wherein the depositing the second protective layer on the upper surface of the wafer comprises:
depositing a fluoropolymer layer as the second protective layer on the upper surface of the wafer by means of plasma assisted deposition, wherein the second chemical solution is a mixed solution containing hydrofluoric acid.

11. The method according to any one of claims 1 to 10, wherein the wafer comprises an insulating layer, the insulating layer is disposed below the each chip region, and the insulating band and the insulating layer are connected.

12. The method according to claim 10, wherein the thinning the back surface of the wafer to obtain the packaged discrete device for the each chip region comprises:
thinning the back surface of the wafer to expose the insulating layer, and dicing along the insulating band to obtain the packaged discrete device for the each chip region.

13. The method according to any one of claims 1 to 12, wherein the thinning the back surface of the wafer comprises:
thinning the back surface of the wafer by means of at least one of lapping, grinding, chemical mechanical polish, dry polishing, electrochemical etching, wet etching, plasma assisted chemical etching and atmospheric downstream plasma etching.

14. The method according to any one of claims 1 to 13, wherein the fabricating the insulating layer on the upper surface of the wafer comprises:
depositing an insulating material on the upper surface of the wafer to form the insulating layer.

15. The method according to claim 14, wherein the depositing the insulating material comprises:
depositing the insulating material by means of at least one of physical vapor deposition, chemical vapor deposition, spraying and spin-coating.

16. The method according to claim 14 or 15, wherein the insulating material comprises at least one of a silicon oxide, a silicon nitride, and a polymer.

17. The method according to any one of claims 1 to 16, wherein the depositing the conductive material comprises:
depositing the conductive material by means of at least one of atomic layer deposition, physical vapor deposition, metal-organic chemical vapor deposition, evaporation, and electroplating.

18. The method according to claim 17, wherein the conductive material comprises at least one of heavily doped polysilicon, carbon-based material, metal, and titanium nitride.

19. The method according to any one of claims 1 to 18, wherein the insulating band is grid-shaped as a whole.

20. A chip packaging method, comprising:
fabricating an insulating band on a scribe line of a wafer, wherein a front surface of the wafer is provided with a plurality of independent chip regions, a portion between any two adjacent chip regions of the plurality of chip regions is the scribe line, and between the any two adjacent chip regions, a depth of the insulating band is greater than or equal to a thickness of the chip region and less than or equal to a thickness of the wafer, and a width of the insulating band is less than or equal to a width of the scribe line;
fabricating a first insulating layer on an upper surface of the wafer;
fabricating at least one first window on the first insulating layer above each of the plurality of chip regions to expose each chip region;
depositing a conductive material in the at least one first window to form at least one first bonding pad of the each chip; and
thinning a back surface of the wafer to expose the insulating band; and
depositing a conductive material on a back surface of a thinned wafer to form a second bonding pad for the each chip region, and dicing along the insulating band to obtain a packaged discrete device for the each chip region.

21. The method according to claim 20, wherein the depositing the conductive material on the back surface of the thinned wafer to form the second bonding pad for the each chip region comprises:
depositing an insulating material on the back surface of the thinned wafer to form a second insulating layer;
fabricating, on the second insulating layer below the each chip region, at least one second window to expose the each chip region; and
depositing a conductive material in the at least one second window to form the at least one second bonding pad of the each chip.

22. The method according to claim 21, wherein a material of the first insulating layer is the same as that of the second insulating layer.

23. The method according to any one of claims 20 to 22, wherein the fabricating the insulating band on the scribe line of the wafer comprises:
fabricating, on the scribe line, a trench surrounding the each chip region, wherein a depth of the trench is greater than or equal to a thickness of a surrounded chip region and less than or equal to a thickness of the wafer; and
depositing an insulating material inside the trench to form the insulating band.

24. The method according to claim 23, wherein the fabricating, on the scribe line, the trench surrounding the each chip region comprises:
fabricating the trench on the scribe line by means of at least one of dry etching, wet etching and mechanical cutting.

25. The method according to claim 24, wherein the fabricating the trench on the scribe line by means of at least one of dry etching, wet etching and mechanical cutting comprises:
depositing a first protective layer on the upper surface of the wafer;
fabricating a third window on the first protective layer above the scribe line; and
etching the wafer in a first chemical solution to obtain the trench at the third window.

26. The method according to claim 25, wherein the depositing the first protective layer on the upper surface of the wafer comprises:
depositing a silicon nitride layer as the first protective layer on the upper surface of the wafer by means of plasma assisted deposition, wherein the first chemical solution is any one of a potassium hydroxide solution, a sodium hydroxide solution, a tetramethylammonium hydroxide solution and a mixed solution containing hydrofluoric acid and nitric acid.

27. The method according to any one of claims 23 to 26, wherein
the trench is trapezoidal with a bottom width smaller than an upper width; or
the trench is rectangular with a bottom width equal to an upper width.

28. The method according to any one of claims 20 to 22, wherein the fabricating the insulating band on the scribe line of the wafer comprises:
converting a portion of the scribe line surrounding the each chip region into a porous silicon region by electrochemical etching, wherein the porous silicon region is the insulating band.

29. The method according to claim 28, wherein the converting the portion of the scribe line surrounding the each chip region into the porous silicon region by the electrochemical etching comprises:
depositing a second protective layer on the upper surface of the wafer;
fabricating a fourth window on the second protective layer above the scribe line; and
placing the wafer in a second chemical solution to obtain the porous silicon region at the fourth window by the electrochemical etching.

30. The method according to claim 29, wherein the depositing the second protective layer on the upper surface of the wafer comprises:
depositing a fluoropolymer layer as the second protective layer on the upper surface of the wafer by means of plasma assisted deposition, wherein the second chemical solution is a mixed solution containing hydrofluoric acid.

31. The method according to any one of claims 20 to 30, wherein a material of the first bonding pad is the same as that of the second bonding pad.

32. The method according to any one of claims 20 to 31, wherein the thinning the back surface of the wafer comprises:
thinning the back surface of the wafer by means of at least one of lapping, grinding, chemical mechanical polish, dry polishing, electrochemical etching, wet etching, plasma assisted chemical etching and atmospheric downstream plasma etching.

33. The method according to any one of claims 20 to 32, wherein the fabricating the insulating layer on the upper surface of the wafer comprises:
depositing an insulating material on the upper surface of the wafer to form the insulating layer.

34. The method according to claim 33, wherein the depositing the insulating material comprises:
depositing the insulating material by means of at least one of physical vapor deposition, chemical vapor deposition, plasma assisted deposition, spraying and spin-coating.

35. The method according to claim 33 or 34, wherein the insulating material comprises at least one of a silicon oxide, a silicon nitride, and a polymer.

36. The method according to any one of claims 20 to 35, wherein the depositing the conductive material comprises:
depositing the conductive material by means of at least one of atomic layer deposition, physical vapor deposition, metal-organic chemical vapor deposition, evaporation, and electroplating.

37. The method according to claim 36, wherein the conductive material comprises at least one of heavily doped polysilicon, carbon-based material, metal, and titanium nitride.

38. The method according to any one of claims 20 to 37, wherein the insulating band is grid-shaped as a whole.
